# DEMANDE DE BREVET EUROPEEN

(11) **EP 0 643 459 A1**
(43) Date de publication de la demande: **15.03.1995**
(21) Numéro de dépôt: 94401983.5
(22) Date de dépôt: 07.09.1994
(51) Int. Cl.: H01S 3/103, H01S 3/25, G02F 2/00, H04B 14/02, H04J 14/00

(54) **Procédé de transposition de modulation optique simultanément sur plusieurs longueurs d'onde**

(30) Priorité: 09.09.1993 FR 9310738
(71) Demandeur: FRANCE TELECOM, F-75015 Paris (FR)
(72) Inventeur: Dupont, Hervé, F-22300 Lannion (FR); Chawki, Mouhamad, F-22300 Lannion (FR); Claveau, Georges, F-22450 Camlez (FR)
(74) Mandataire: Dubois-Chabert, Guy

(57) **Abrégé**

On utilise un laser à semiconducteur apte à osciller librement sur plusieurs modes longitudinaux, ce laser étant susceptible de se verrouiller sur un faisceau optique incident. La modulation se trouve transposée sur les modes (λ₂₁,λ₂₂,λ₂₃, ...) qui ne sont pas à la longueur d'onde (λ₁) du faisceau incident.

Application en télécommunications optiques.

## Description

### Domaine technique

La présente invention a pour objet un procédé de transposition de modulation optique simultanément sur plusieurs longueurs d'onde.

Elle trouve une application en télécommunications optiques.

### Etat de la technique

L'introduction de l'optique dans les réseaux de télécommunications vient de la grande capacité de transmission qu'offrent les liaisons optiques. Afin de profiter pleinement de cet avantage et obtenir une transparence optique sur tout le réseau, il est nécessaire de limiter au maximum l'emploi de connexions optique/électrique et électrique/optique. C'est dans ce but que les amplificateurs optiques (à fibres dopées ou à semiconducteur) ont été développés. En assurant la régénération tout-optique des signaux, ils permettent de supprimer les répéteurs électriques.

Dans un réseau de télécommunications utilisant plusieurs longueurs d'onde (réseau dit "multicolore"), l'opération de routage (appelée commutation spatiale de circuits ou commutation en longueur d'onde) implique des fonctions de base qui sont remplies par des émetteurs accordables en longueurs d'onde, des coupleurs étoiles de grande capacité ou des filtres optiques accordables. A ces fonctions doit être ajoutée celle de transposition de longueur d'onde consistant à transférer l'information d'une porteuse optique sur une autre. Elle permet non seulement l'aiguillage d'une information dans un réseau par "coloration" du signal, mais aussi la connexion entre deux réseaux locaux multicolores.

Pour obtenir cette transposition, une possibilité consiste à détecter l'information reçue sur une longueur d'onde et à utiliser le signal électrique résultant pour moduler un laser émettant à une autre longueur d'onde.

Un tel dispositif capable de remplir cette fonction, peut se présenter sous deux formes différentes :
- dans la première, l'information se trouvant initialement sur une longueur d'onde λ₀ fixe est transposée vers une autre longueur d'onde λ_{*i*} choisie parmi n longueurs d'onde possibles ; on peut ainsi successivement accéder, en sortie du dispositif, à l'information sur l'une quelconque des longueurs d'onde λ₁, λ₂,...,λ_{*n*}.
- dans la seconde, l'information parvient au dispositif sur une longueur d'onde λ_{*i*} sélectionnée entre n longueurs d'onde possibles et le dispositif transfère le signal sur une autre longueur d'onde fixe λ₀.

Jusqu'à présent, cette opération de transposition a été obtenue à l'aide de diodes lasers et d'amplificateurs à semi-conducteurs. Dans le premier cas, on agit sur la longueur d'onde d'émission d'un laser monomode de type DFB ("Distributed FeedBack") ou DBR ("Distributed Bragg Reflection"), par injection optique dans la zone active.

C'est ce qui est décrit dans les deux articles suivants :
- P. POTTIER, M.J. CHAWKI, R. AUFFRET, G. CLAVEAU, A. TROMEUR, "1.5 Gbit/s transmission system using all optical wavelength convertor based on tunable two-electrode DFB laser", Electron. Lett., vol. 27, pp. 2183-2184, 1991 ;
- B. MIKKELSEN, T. DURHUUS, R.J. PEDERSEN, K.E. STUBKJAER, "Penalty free wavelength conversion of 2.5 Gbit/s signals using a tuneable DBR-laser", Proc. ECOC'92, Berlin, septembre 1992.

Quant aux amplificateurs à semi-conducteurs, ils utilisent soit le phénomène de variation de saturation du gain, soit le mélange à quatre ondes, pour provoquer la transposition.

C'est ce qui est décrit dans les deux articles suivants :
- J.M. WIESENFELD, B. GLANCE, "Cascadability and fanout of semiconductor optical amplifier wavelength shifter", IEEE Photon. Technol. Lett., vol. 4, pp. 1168-1171, 1992 ;
- G. GROSSKOPF, R. LUDWIG, H.G. WEBER, "140 Mbit/s DPSK transmission using an all-optical frequency convertor with a 4000 GHz conversion range", Electron. Lett., vol. 24, pp. 1106-1107, 1988.

Quelle que soit la technique employée, la sélection de longueur d'onde à partir de laquelle ou vers laquelle on transpose le signal est réalisée de manière séquentielle et non parallèle : à un instant donné, une seule longueur d'onde est impliquée par le phénomène de transposition.

Les réseaux utilisant ces mécanismes de transposition manquent donc de souplesse.

La présente invention a justement pour but de remédier à cet inconvénient. A cette fin, elle propose un procédé qui permet de transposer simultanément l'information sur différentes longueurs d'onde. Ceci implique que, par simple ajustement d'un filtre optique accordable en sortie du dispositif de transposition, on sélectionne le signal transposé sur la longueur d'onde désirée. Mais on peut aussi laisser passer toutes les longueurs d'onde et transmettre ainsi l'information vers de multiples récepteurs. Ce sont autant d'éléments apportant de la souplesse au réseau de télécommunications. Par ailleurs, la transposition s'effectue sans changement de format de modulation (les signaux d'entrée et de sortie sont modulés tous deux en amplitude) ou avec changement du format (le signal incident est modulé en fréquence et le signal émergent en amplitude).

### Exposé de l'invention

Ces résultats sont obtenus selon l'invention grâce à un procédé qui consiste à :
- utiliser un laser à semiconducteur apte à osciller librement sur plusieurs modes longitudinaux, ce laser étant susceptible de se verrouiller sur un faisceau optique incident si celui-ci présente un désaccord en fréquence approprié par rapport à l'un de ses modes longitudinaux et une puissance optique appropriée,
- injecter dans ce laser un faisceau optique véhiculant le signal modulé à transposer,
- régler la modulation et la longueur d'onde de ce signal de telle sorte que, pour l'un des états extrêmes du signal modulé, le laser soit verrouillé sur le faisceau incident et n'émette que sur le seul mode longitudinal correspondant à la longueur d'onde du faisceau incident et que, pour un autre état extrême du signal modulé, le laser ne soit pas verrouillé sur le faisceau incident et oscille simultanément sur plusieurs modes longitudinaux,
- utiliser le faisceau émis par le laser, qui comprend une pluralité de modes longitudinaux sur lesquels la modulation a été transposée simultanément.

La transposition peut être obtenue quel que soit le type de modulation utilisée sur le faisceau incident, en amplitude ou en fréquence. Cependant, le faisceau émergent se retrouve dans tous les cas modulé en amplitude.

### Brève description des dessins

- la figure 1 est un schéma de principe du verrouillage de deux lasers par injection optique,
- la figure 2 montre le domaine d'accrochage d'un laser en fonction du désaccord fréquentiel entre les largeurs d'onde du signal injecté et du mode injecté,
- la figure 3 illustre un montage expérimental permettant de mettre en oeuvre et de tester le procédé de l'invention,
- la figure 4 montre un spectre d'émission d'un laser multimode en l'absence d'injection optique (a) et en présence d'injection optique (b) ;
- la figure 5 montre un agrandissement d'un spectre d'émission d'un laser,
- la figure 6 montre divers signaux modulés délivrés par le laser sur plusieurs longueurs d'onde, et résultant du phénomène de transposition,
- la figure 7 montre la réponse en modulation d'amplitude pour un signal transposé.

### Exposé détaillé de modes de réalisation

Le procédé de l'invention s'appuie sur la technique connue du verrouillage des lasers à semiconducteur par injection optique, mais dans le cadre très particulier des lasers oscillant ou susceptibles d'osciller sur une pluralité de modes longitudinaux.

Le phénomène de verrouillage de phase par injection optique (en anglais "injection locking") est déjà utilisé dans des systèmes de transmission optique [P. DOUARE, "Optical Phase Modulation Behaviour of an Injection-Locked Semiconductor Laser for an Optical Transmission System", Opt. Commun., vol. 12, 2, pp.64 68, 1991.

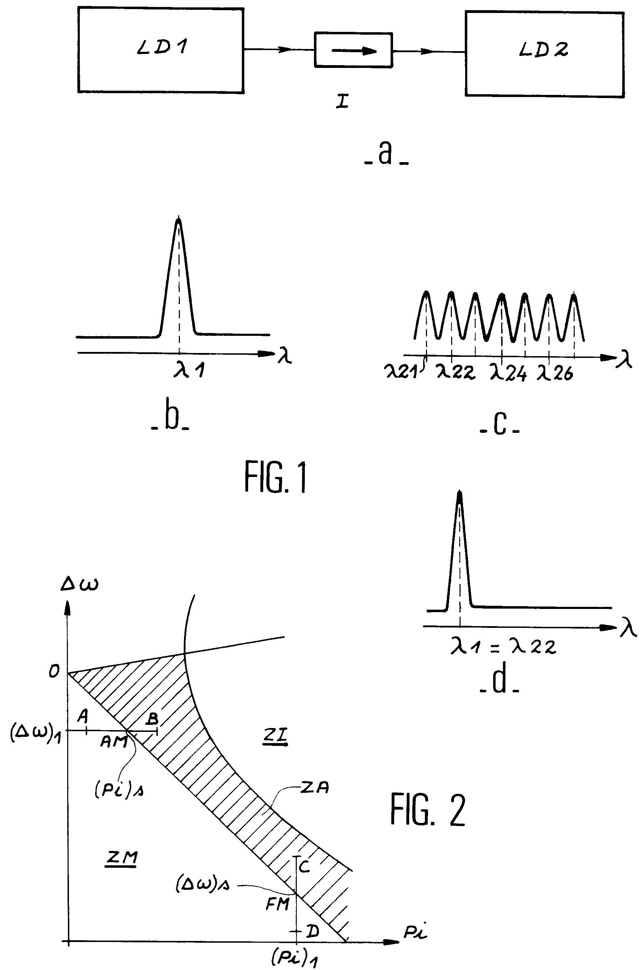

Les principes physiques mis en oeuvre sont illustrés sur les figures 1 et 2.

Sur la figure 1, tout d'abord, on voit, partie a, un premier laser à semiconducteur LD1 monomode émettant sur une seule longueur d'onde λ₁. Le spectre est schématiquement représenté sur la partie b. Un second laser LD2 fonctionne, lui, en régime multimodes longitudinaux. Le spectre de ces modes est représenté schématiquement sur la partie c. Ces modes sont situés à des longueurs d'onde λ₂₁, λ₂₂, λ₂₃, etc..., tous écartés d'une même quantité c/2nL, si L est la longueur du résonateur utilisé et n l'indice de réfraction du semiconducteur.

En l'absence d'injection optique, tous ces modes oscillent.

Si l'injection optique à la longueur d'onde λ₁ coïncide avec un mode longitudinal (par exemple le mode à la longueur d'onde λ₂₂ comme sur la partie d), c'est ce mode qui sera privilégié et le laser se verrouillera sur cette longueur d'onde λ₁=λ₂₂. Tous les autres modes seront "éteints".

Pour contraindre le laser LD2 à émettre uniquement sur une longueur d'onde λ_{2*i*}, une double condition doit être remplie sur la puissance injectée Pi et sur le désaccord fréquentiel Δω=2π*c*(1/λ₁ - 1/λ_{2*i*}) où λ_{2*i*} est la longueur d'onde de l'un des modes de LD2. Cette double condition définit une zone d'accrochage à l'intérieur de laquelle le verrouillage des deux lasers est observé. C'est ce qui est représenté sur la figure 2 où la puissance Pi est portée en abscisses et le désaccord Δω en ordonnées. La zone d'accrochage est la zone hachurée référencée ZA. Une zone d'instabilité est référencée ZI et une zone de modulation par ZM.

En modulation d'amplitude, le fonctionnement sera donc le suivant. Le désaccord fréquentiel par rapport à l'un des modes du laser LD2 est fixe et présente la valeur (Δω)1. Pour ce désaccord, il existe un seuil de puissance, noté (Pi)s, au-delà duquel on est dans la zone d'accrochage ZA et en deçà duquel on est hors de cette zone et plus précisément dans la zone de modulation ZM. La modulation d'amplitude du faisceau incident injecté est donc réglée pour que le point de fonctionnement passe alternativement du point marqué A (hors zone d'accrochage) au point marqué B (dans la zone d'accrochage). Le laser oscillera donc alternativement sur tous ses modes lorsque le point de fonctionnement sera en A, ou seulement sur le mode verrouillé à la longueur d'onde λ₁ lorsque le point de fonctionnement sera en B, les autres étant éteints.

Tous les modes situés à des longueurs d'onde différentes de λ₁ se trouvent donc alternativement oscillants et éteints. Ils sont donc modulés en amplitude. La modulation d'amplitude a ainsi été transposée simultanément sur tous les modes autres que le mode à la longueur d'onde λ₁.

On observera que la modulation obtenue sur tous ces modes est complémentaire de la modulation incidente puisque, lorsque le signal incident est au niveau haut (point B) les modes sont éteints, donc au niveau bas et vice versa.

Quant au mode verrouillé à λ₁, il reproduit la modulation incidente, directement.

Un mécanisme similaire se développe pour un signal incident modulé en fréquence. Dans ce cas, la puissance est constante, soit (Pi)1, et c'est l'écart fréquentiel qui varie. Il existe un seuil noté (Δω)s au-delà duquel il y a accrochage du laser LD2 sur le faisceau incident (point marqué C) et en deçà duquel l'accrochage est impossible (point marqué D). On retrouve donc, dans ce cas encore, des modes alternativement éteints par l'accrochage sur λ₁ (point C) ou oscillants (point D). La transposition se fait encore simultanément sur une pluralité de modes.

On observera donc que, selon l'invention, le format de la modulation est modifié ou non : une modulation d'amplitude ou de fréquence sur le signal incident est transposée en une modulation d'amplitude.

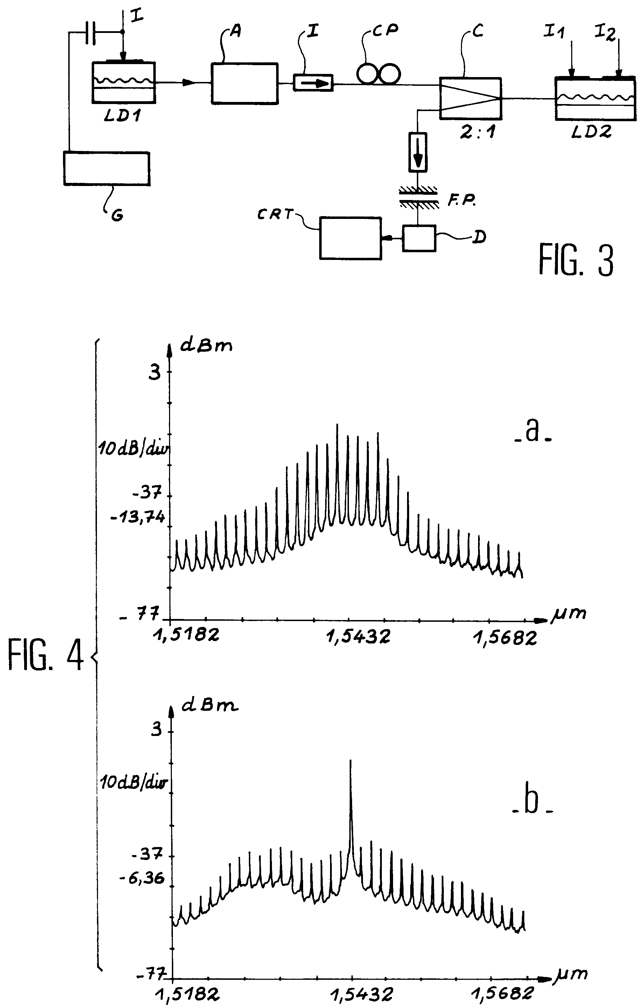

La figure 3 illustre un montage expérimental permettant de tester le procédé de l'invention. Ce montage comprend une diode laser LD1 de type laser DFB mono-électrode dont le courant d'alimentation est modulé autour de I=30 mA par un générateur G. Le faisceau émis est situé à la longueur d'onde λ₁ =1542,2 nm. Le signal optique traverse ensuite un amplificateur optique A puis un isolateur I, et se propage dans une fibre optique, puis dans un contrôleur de polarisation CP qui permet d'ajuster le plan de polarisation de la lumière injectée de telle manière à la rendre transverse-électrique. La lumière est alors injectée dans la zone active d'une diode laser DFB biélectrode LD2 dont le spectre est multimode. Etant donné la correspondance entre la longueur d'onde λ₁ de la source et l'un des pics de résonance du laser LD2, ce dernier se synchronise sur le laser LD1.

La lumière provenant du laser-convertisseur LD2 est récupérée par la même face avant qui a permis l'injection et est dirigée à travers le coupleur C de type 2 vers 1 vers un filtre FABRY-PEROT FP. Le filtre, d'une finesse de 100 et d'une largeur à mi-hauteur de 3,3 nm (43 GHz), sélectionne alors une des longueurs d'onde sur lesquelles l'information a été transposée. Le signal obtenu est détecté à l'aide d'un détecteur D de type photodiode PIN. Le signal détecté est observé sur l'écran d'un oscilloscope CRT.

Ce montage permet d'effectuer deux types d'étude, l'une statique, l'autre dynamique :

### a) Etude statique

L'effet de verrouillage par injection optique sur l'émission du laser multimode LD2 est illustré par les deux spectres de la figure 4.

En l'absence de lumière injectée et lorsque les courants d'alimentation du laser LD2 sont respectivement ***I***₁=**47,5** mA et ***I***₂=**52,6** mA, le laser LD2 émet sur une dizaine de modes espacés les uns des autres de 1,43 nm (fig. 4a). Pour chacun d'eux, on dispose d'une puissance optique d'environ -10 dBm à la sortie du laser, soit 100 µW.

En revanche, quand on injecte de la lumière dans le laser LD2 à la longueur d'onde ***I***₁=**1543,2** nm qui coïncide avec la longueur d'onde de l'un des modes auto-oscillant de la cavité, le laser LD2 devient monomode (fig. 4b).

Ainsi, les modes qui oscillaient initialement et qui sont situés dans une bande spectrale d'une douzaine de nanomètres autour de la longueur d'onde λ₁ s'éteignent ou sont atténués fortement. La différence de puissance émise sur chacun de ces dix modes, entre les spectres mesurés avec et sans injection, donne un taux d'extinction de 20 dB.

Ce résultat a été obtenu pour une puissance optique constante à l'entrée du système d'injection d'environ 500 µW. Un traitement antireflet de la face du laser par laquelle on injecte le faisceau incident permettrait de réduire les pertes d'insertion et donc de diminuer cette puissance. En outre, le phénomène est également observé pour les modes se trouvant plus éloignés spectralement. Cependant, pour ceux-ci, l'auto-oscillation étant plus faible, l'effet du verrouillage par injection optique est moindre.

### b) Etude dynamique

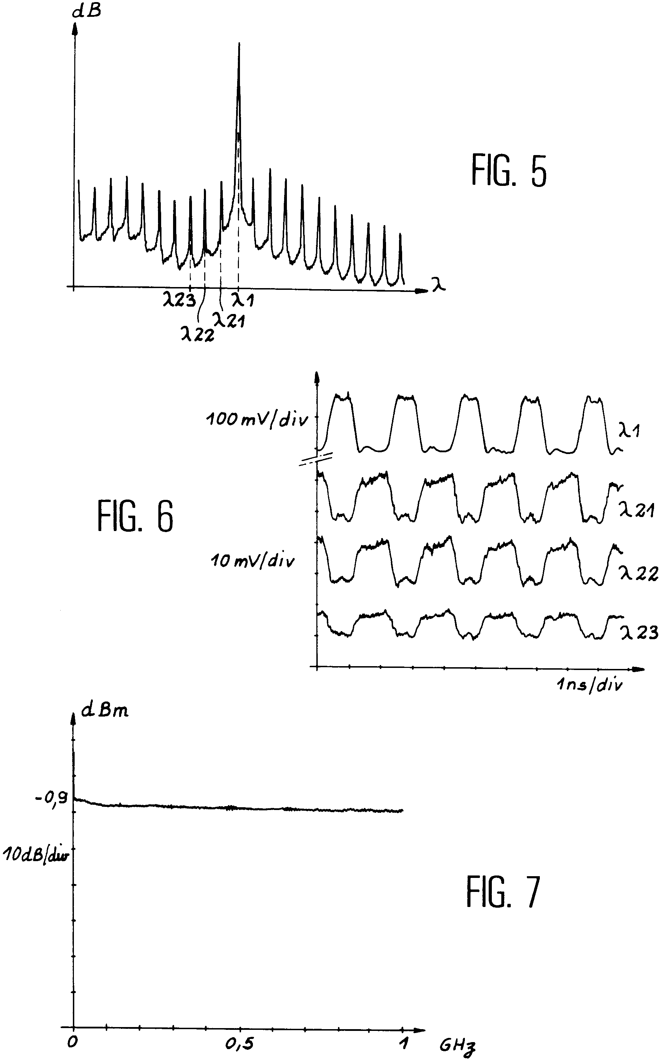

Le signal optique injecté dans le laser LD2 est modulé en amplitude à 500 MHz et sa longueur d'onde est toujours λ₁=1543,2 nm (fig. 5). On observe bien la transposition de l'information sur les autres modes de la cavité LD2 sur la figure 6. Sur cette figure, les trois traces du bas représentent les signaux transposés sur trois de ces modes (λ₂₁=1541,8 nm ; λ₂₂=1540,3 nm ; λ₂₃=1538, 9 nm). En tout, la conversion de longueur d'onde a été détectée sur huit modes, donc sur une plage de 12 nm de part et d'autre de la longueur d'onde λ₁. De plus, on récupére sur la longueur d'onde λ₁, le même signal que le signal source (fig. 6, trace du haut), alors que sur les longueurs d'onde λ₂₁,λ₂₂ et λ₂₃, on obtient le signal complémenté.

La réponse en fréquence du phénomène de transposition reste plate jusqu'à 1 GHz comme en témoigne la figure 7 où la fréquence est portée en abscisses.

Après cette description, on voit que le procédé de l'invention permet la transposition d'une information à haut débit, d'une longueur d'onde sur plusieurs autres longueurs d'onde et cela simultanément. En outre, l'utilisation du phénomène de verrouillage par injection optique permet d'obtenir un contraste élevé des signaux transposés, puisque l'étude statique a montré un taux d'extinction pour la dizaine de modes auto-oscillant du laser-convertisseur de plus de 20 dB lors de l'injection de 500 µW. Enfin, si dans l'expérimentation décrite, le laser utilisé possédait dix modes auto-oscillant, rien n'empêche d'utiliser des lasers contenant plus de dix modes (à condition de se doter d'un détecteur à amplification et sensibilité élevées). Cela accroît d'autant le nombre de longueurs d'onde vers lesquelles la transposition est réalisable.

## Revendications

1. Procédé de transposition en longueur d'onde d'un signal optique modulé, caractérisé par le fait qu'il consiste à :
- utiliser un laser à semiconducteur (LD2) apte à osciller librement sur plusieurs modes longitudinaux, ce laser étant susceptible de se verrouiller sur un faisceau optique incident si celui-ci présente un désaccord en fréquence (Δω) approprié par rapport à l'un des modes longitudinaux du laser et une puissance optique (Pi) appropriée,
- injecter dans ce laser (LD2) un faisceau optique véhiculant le signal modulé à transposer,
- régler la modulation et la longueur d'onde de ce signal de telle sorte que, pour l'un des états extrêmes du signal modulé (BC), le laser (LD2) soit verrouillé sur le faisceau incident et n'émette que sur le seul mode longitudinal correspondant à la longueur d'onde (λ₁) du faisceau incident et que, pour un autre état extrême du signal modulé (AD), le laser ne soit pas verrouillé sur le faisceau incident et oscille simultanément sur plusieurs modes longitudinaux (λ₂₁,λ₂₂,λ₂₃),
- utiliser le faisceau émis par le laser, qui comprend une pluralité de modes longitudinaux sur lesquels la modulation a été transposée simultanément.

2. Procédé selon la revendication 1, caractérisé par le fait que le faisceau incident est modulé en amplitude et possède une longueur d'onde (λ₁) déterminée égale à celle de l'un des modes longitudinaux du laser (LD2), la puissance (Pi) du faisceau incident étant modulée entre une première valeur (B) supérieure à une puissance de seuil ((Pi)s) au-delà de laquelle le laser se verrouille sur le faisceau incident et en deçà de laquelle le laser n'est pas verrouillé et oscille librement, et une seconde valeur (A) inférieure audit seuil ((Pi)s).

3. Procédé selon la revendication 1, caractérisé par le fait que le faisceau incident est modulé en fréquence et présente une puissance déterminée constante ((Pi)1), la fréquence du faisceau incident étant modulée entre une première valeur (C) supérieure à une valeur de seuil ((Δω)s) au-delà de laquelle le laser se verrouille sur le faisceau incident et en deçà de laquelle le laser n'est pas verrouillé et oscille librement, et une seconde valeur (D) inférieure à cette valeur de seuil ((Δω)s).
